# FASCICULE DE BREVET EUROPEEN

(11) **EP 0 851 295 B1**
(45) Date de publication et mention de la délivrance du brevet: **24.10.2001**
(21) Numéro de dépôt: 97122259.1
(22) Date de dépôt: 17.12.1997
(51) Int. Cl.: G03F 7/00

(54) **Procédé de fabrication de microstructures par conformation multicouche d'une résine photosensible et microstructures ainsi obtenues**
Verfahren zur Herstellung von Mikrostrukturen durch Mehrschicht-Strukturierung eines Photolackes und damit hergestellte Mikrostrukturen
Process for the fabrication of microstructures by multilayer conformation of a photosensitive resin et microstructures obtained therewith

(30) Priorité: 27.12.1996 FR 9616130
(43) Date de publication de la demande: 01.07.1998
(73) Titulaire: Mimotec SA, 1950 Sion (CH)
(72) Inventeur: Lorenz, Hubert, 1003 Lausanne (CH); Guérin, Louis, 1007 Lausanne (CH); Renaud, Philippe, 1028 Préverenges (CH)
(74) Mandataire: Thérond, Gérard Raymond

(56) Documents cités:
- US-A- 4 058 401
- US-A- 5 198 402
- LOECHEL B ET AL: "APPLICATION OF ULTRAVIOLET DEPTH LITHOGRAPHY FOR SURFACE MICROMACHINING" JOURNAL OF VACUUM SCIENCE AND TECHNOLOGY: PART B, vol. 13, no. 6, 1 novembre 1995, pages 2934-2939, XP000571136
- ANONYMOUS: "Improved Developer Composition for Soldermasks." IBM TECHNICAL DISCLOSURE BULLETIN, vol. 33, no. 6B, novembre 1990, NEW YORK, US, pages 412-413, XP002040237

## Description

La présente invention a pour objet un procédé de fabrication de microstructures tridimensionnelles par conformation d'au moins deux couches épaisses d'une résine photosensible aux rayons ultraviolets. L'invention concerne également les microstructures ainsi obtenues de façon replicable avec une très bonne définition pour un coût unitaire avantageux, et possédant une épaisseur suffisante de l'ordre du millimètre pour supporter des contraintes mécaniques lorsqu'elles sont utilisées soit directement, par exemple comme composants en micromécanique, soit indirectement comme structures positives sacrificielles pour la fabrication de micro-moules métalliques.

La production de microstructures tridimensionnelles a pris son essor dans les années 80 avec la méthode conçue par W. Ehrfeld du Karlsruhe Nuclear Research Center (Allemagne) et connue sous l'acronyme LIGA (Lithographie, Galvanisierung, Abformung). Dans son principe la technique LIGA consiste :
1) à déposer sur un substrat une couche de 10 à 1'000 µm d'un photorésist positif (généralement du polyméthylmétacrylate PMMA) ;
2) à effectuer à travers un masque une irradiation X au moyen d'un synchrotron;
3) à développer, c'est-à-dire à éliminer par des moyens physiques ou chimiques les portions de photorésist dépolymérisé. Le procédé LIGA, et les procédés dérivés faisant toujours appel à une irradiation X, permettent d'obtenir des microstructures ayant un rapport d'aspect élevé, valeur définie comme étant le quotient de la hauteur par la largeur de la ligne ou de la tranchée la plus fine et constituant un critère d'appréciation de la verticalité des parois. La qualité des microstructures obtenues ne prête pas à critique, mais le fait de devoir mettre en oeuvre un équipement coûteux (synchrotron) rend cette technique peu compatible avec une production de masse de microstructures devant avoir un faible coût unitaire.

Pour réduire les coûts, les recherches se sont orientées vers le procédé dit "LIGA du pauvre" dans laquelle la sensibilisation d'une couche de photorésist est produite par le rayonnement ultraviolet d'une aligneuse conventionnelle. L'épaisseur maximum des microstructures actuellement obtenues avec ce procédé est comprise entre 80 µm et 200 µm. Pour augmenter cette épaisseur, il est proposé dans le brevet DE 4 400 315 de répéter plusieurs fois le procédé en faisant entre chaque couche de photorésist un dépôt intercalaire métallique d'accrochage pour atteindre une épaisseur totale encore limitée à 400 µm, en ayant en outre une étape de développement plus complexe en raison des dépôts métalliques. De plus, on fera observer que le nombre d'étapes et la présence de dépôts métalliques intercalaires contribuent à augmenter sensiblement le coût et à avoir un impact négatif sur la qualité des parois.

La présente invention a donc pour but de remédier aux inconvénients de cet art antérieur en procurant un procédé de structuration d'un photorésist négatif par rayonnement ultraviolet dans lequel le choix particulier du photorésist permet de façon surprenante de structurer au moins deux couches épaisses successives, sans dépôt métallique intercalaire et d'obtenir ainsi à faible coût unitaire des microstructures tridimensionnelles complexes avec une épaisseur pouvant aller au moins jusqu'au millimètre, tout en présentant un rapport d'aspect supérieur à ceux obtenus jusqu'alors par structuration UV.

A cet effet, l'invention a pour objet un procédé de fabrication d'une microstructure tridimensionnelle, caractérisé en ce qu'il comprend les étapes consistant à :
a) créer sur une plaquette-support un revêtement sacrificiel;
b) étaler en une seule fois une couche de photorésist négatif, sensible au rayonnement ultraviolet, d'une épaisseur comprise entre 150 µm et 700 µm, ledit photorésist étant formé par une laque contenant une composition époxy polyfonctionnelle et un photoinitiateur choisi parmi les sels de triarylsulfonium;
c) chauffer ladite couche entre 90 et 95°C pendant une durée dépendant de l'épaisseur déposée;
d) effectuer à travers un masque correspondant à l'empreinte désirée une illumination UV de 200 à 1'000 mJ.cm⁻², mesurée à une longueur d'onde de 365 nm selon l'épaisseur de la couche;
e) effectuer un recuit de ladite couche pour provoquer la polymérisation;
f) reproduire au moins une fois les étapes b) à e) en utilisant, si nécessaire en fonction du contour désiré pour la structuration de la nouvelle couche de photorésist, un masque différent pour l'étape d);
g) procéder en une ou plusieurs fois au développement par dissolution du photorésist non exposé au moyen d'un solvant choisi parmi la GBL (gammabutyrolactone) et le PGMEA (propylène glycol méthyle éthyle acétate), et
h) séparer de la plaquette-support la microstructure obtenue à l'étape g) par dissolution du revêtement sacrificiel.

Le recuit effectué à l'étape e) pour provoquer la polymérisation des zones illuminées par le rayonnement UV est effectué de préférence entre 90°C et 95°C pendant 15 à 30 mn.

Dans le cas où la nouvelle couche de photorésist devant être illuminée (étape f) présente un contour qui n'est pas totalement inscrit dans le contour de la couche inférieure, le dépôt de la nouvelle couche de photorésist est précédé d'une étape i) consistant à effectuer un dépôt métallique (par exemple Cr/Cu), faisant obstacle aux rayons UV pour la fraction de couche inférieure dont la polymérisation n'est pas souhaitée. L'étape supplémentaire i) est en particulier nécessaire lorsque la microstructure devant être obtenue présente une cavité. Dans ce cas, il sera également nécessaire de répéter l'étape g) de développement après l'étape h) de libération de la structure.

Dans le cas où la microstructure obtenue à l'issue de l'étape g) doit servir de gabarit à la fabrication d'un micromoule métallique, on effectue avant l'étape h) une étape supplémentaire ii) consistant en une métallisation primaire sur toute la surface de ce gabarit, puis on procède au recouvrement complet de tout l'ensemble par des dépôts électrolytiques successifs, de façon à former un bloc qui sera ultérieurement usiné pour être adapté à une machine d'injection de matériaux plastiques en fusion. Après avoir libéré le bloc du substrat (étape h) il est encore nécessaire lors d'une étape supplémentaire iii) d'éliminer le gabarit, par des moyens physiques ou chimiques.

La plaquette-support utilisée dans la première étape est par exemple formée par une plaquette de silicium, de verre ou de céramique sur laquelle on a déposé par évaporation, une mince couche sacrificielle d'aluminium d'environ 100 nm. Dans ce cas, pour libérer la structure dans la dernière étape on effectue une attaque alcaline. De façon équivalente, on peut utiliser un matériau plastique composite assurant à la fois une bonne adhésion entre la plaque-support et les dépôts de photorésist, et une libération facile de la microstructure à l'issue du procédé.

Les masques utilisés (étapes d et f) pour délimiter sur la couche de photorésist la surface devant recevoir le rayonnement UV sont réalisés avec une très haute résolution par les méthodes utilisées dans l'industrie microélectronique. Les plages devant être opaques au rayonnement UV ont par exemple un revêtement métallique de chrome.

Le photorésist utilisé dans le procédé selon l'invention pour effectuer une structuration multicouche est un produit bon marché préparé de préférence à partir d'une résine époxy octofonctionnelle disponible chez Shell Chemical sous la référence SU-8 et d'un photoinitiateur choisi parmi les sels de triarylsulfonium tels que ceux décrits dans le brevet US 4,058,401. Le solvant qui s'est révélé le plus approprié est la gammabutyrolactone (GBL).

La présente invention a également pour objet les microstructures tridimensionnelles obtenues, caractérisées par un rapport d'aspect remarquablement élevé par rapport à celui des structures obtenues jusqu'alors par illumination UV, compte-tenu notamment de l'épaisseur desdites structures. Les essais effectués ont montré que ce rapport pouvait être de l'ordre de 20 pour les structures de ligne et de l'ordre de 15 pour les structures de tranchée.

Les caractéristiques et avantages de l'invention seront mieux compris à la lecture de la description détaillée qui va suivre d'exemples de réalisations de microstructures, en référence aux dessins annexés dans lesquels :
- la figure 1 est une représentation en perspective d'un premier mode de réalisation illustré par une roue dentée surmontée d'un pignon.
- les figures 2 à 5 sont des vues en coupe diamétrale des différentes étapes de fabrication de la microstructure représentée à la figure 1;
- les figures 6 et 7 représentent les étapes supplémentaires permettant d'obtenir un micromoule métallique à partir du gabarit de la figure 5;
- la figure 8 est une représentation en perspective partiellement arrachée d'un deuxième mode de réalisation illustré par un capteur de flux thermique, et
- les figures 9 à 15 sont des vues en coupe schématiques selon la ligne X-X de la figure 8 des différentes étapes de fabrication de la microstructure représentée à la figure 8.

Les exemples ci-après correspondent à trois microstructures obtenues par le procédé selon l'invention

### Exemple 1 : Fabrication d'une roue dentée surmontée d'un pignon

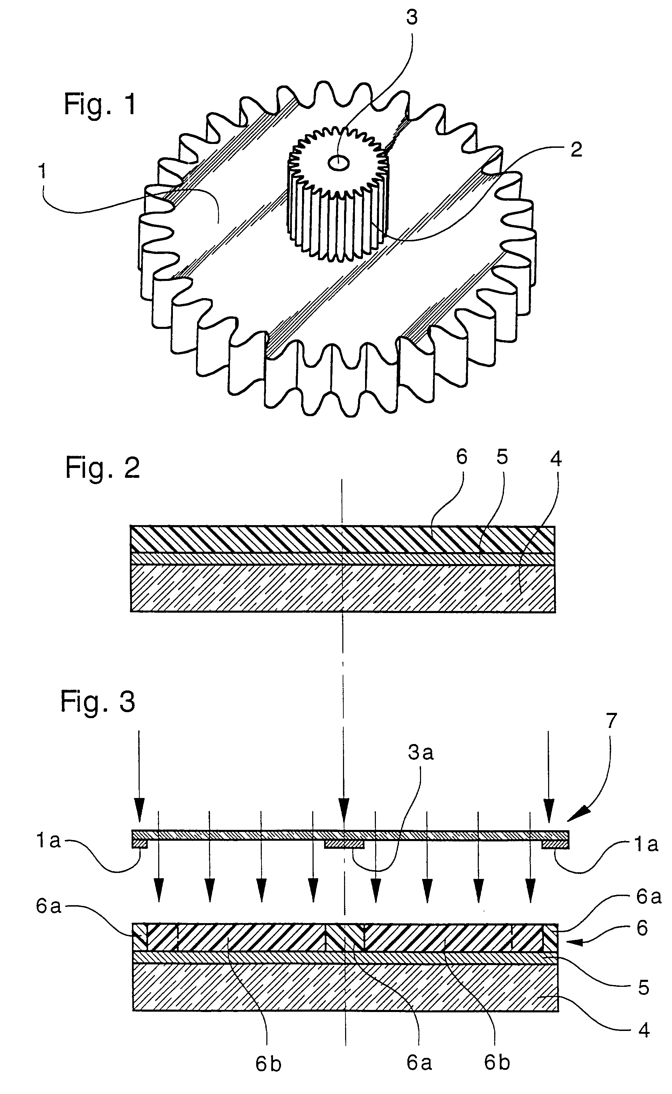

La figure 1 représente une roue dentée 1 surmontée d'un pignon 2, l'ensemble étant traversé de part en part d'un trou d'axe 3. La hauteur de la roue est de 0,23 mm et celle du pignon de 0,45 mm représentant donc une hauteur totale de 0,68 mm avec une tolérance de 10 µm. Les diamètres respectifs sont de 3,037 mm et 0,85 mm avec des tolérances de ± 1 µm. Ainsi, le module d'engrenage peut aller jusqu'à 0,016 mm, c'est-à-dire bien en-dessous du minimum que peuvent actuellement utiliser les constructeurs horlogers lorsque les pièces sont obtenues par moulage dans des moules micro-usinés dans une plaque métallique par la technique bien connue de l'électroérosion à fil (EF).

A la figure 2, on a représenté l'état du produit obtenu à l'issue des trois premières étapes du procédé. Une plaquette-support en silicium 4 de 0,38 mm d'épaisseur et 7,5 cm de diamètre, non oxydée, soigneusement nettoyée et déshydratée est d'abord recouverte d'un revêtement sacrificiel 5 par évaporation d'aluminium. Ce revêtement a typiquement une épaisseur de l'ordre de 100 nm. On procède ensuite à l'étalement d'une couche épaisse 6 de photorésist. La viscosité dynamique de la composition choisie est de l'ordre de 15 Pa·s et permet un étalement classique à la tournette, par exemple au moyen d'un appareil Gyrset® de Karl Süss jusqu'à l'épaisseur désirée, soit 230 µm. La couche déposée est ensuite chauffée à 95°C pour évacuer le solvant qui maintenait le résist à la viscosité voulue.

La figure 3 correspond à l'étape d'illumination du photorésist. A cet effet, on dispose au-dessus de la surface du photorésist un masque 7 comportant des zones transparentes aux rayons UV et des zones opaques formées par des dépôts de chrome. Ces dépôts de chrome suivent d'une part le contour extérieur 1a de la denture de la roue 1, d'autre part le contour intérieur 3a du trou d'axe 3. Le même support formant le masque peut comporter un grand nombre de zones correspondant à autant de microstructures pouvant être fabriquées en un seul lot, toutes les zones étant obtenues avec une très haute résolution du contour par photolithographie, technique bien connue dans l'industrie microélectronique. On procède ensuite à la sensibilisation de la couche 6 de photorésist par illumination UV au moyen d'une aligneuse ayant ses pics d'intensité à 365 nm et 410 nm. On effectue enfin un recuit pendant 25 mn à 95°C qui va provoquer la polymérisation du photorésist dans les zones 6b qui ont reçu le rayonnement UV. Cette partie polymérisée devient insensible à une grande majorité de solvants. Par contre, les zones 6a non illuminées pourront ultérieurement être dissoutes par un solvant.

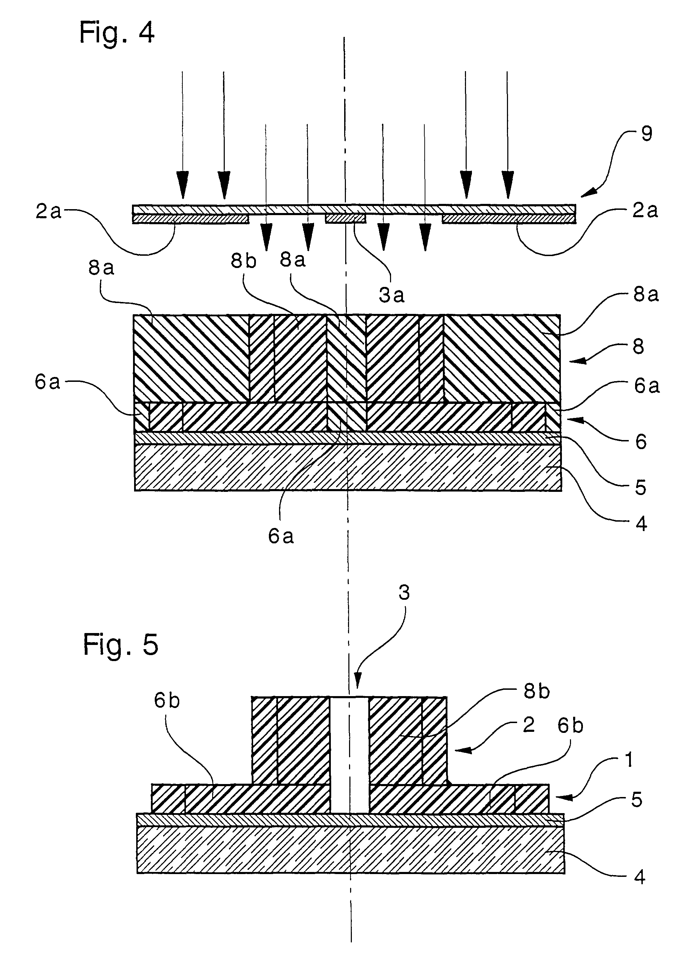

A la figure 4, on a représenté la structuration d'une deuxième couche de photorésist 8, épaisse d'environ 450 µm au moyen d'un deuxième masque 9 dont les dépôts métalliques de chrome 2a, 3a délimitent le contour des zones transparentes aux rayons UV correspondant au pignon 2 et à son trou d'axe 3.

Après recuit, cette deuxième couche de photorésist est structurée en des zones 8a qui seront solubles dans le solvant et des zones 8b polymérisées formant le pignon 2 et son trou d'axe 3.

On procède ensuite à l'élimination des parties 6a, 8a de photorésist non polymérisé pour obtenir la microstructure représentée à la figure 5, toujours solidaire de la plaquette-support 4, et formée des deux niveaux structurés 6b, 8b. A cet effet, on utilise comme solvant le propylène glycol méthyle éther acétate (PGMEA).

Dans une dernière étape (non représentée), on libère la microstructure en attaquant la couche d'accrochage d'aluminium avec K OH (40 %).

### Exemple 2 : Fabrication d'un micro-moule métallique

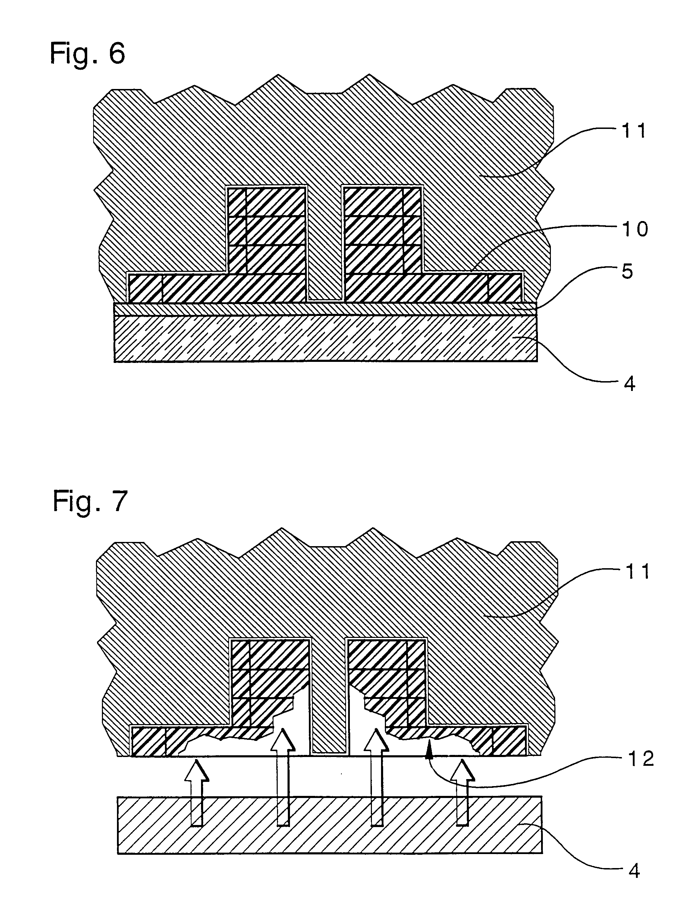

A partir de la microstructure obtenue à l'exemple 1, mais avant de la libérer de la plaquette-support 4, on effectue, comme représenté à la figure 6, un revêtement métallique 10 de toute l'enveloppe extérieure, destinée à accrocher le bloc métallique 11 formé par des dépôts électrolytiques successifs. La métallisation initiale est par exemple effectuée par évaporation de nickel pour former un revêtement 10 ayant 30 à 100 nm. Les étapes de dépôts électrolytiques sont effectuées à partir d'un bain contenant également du nickel ou un alliage l'incorporant, selon les techniques connues en ce domaine.

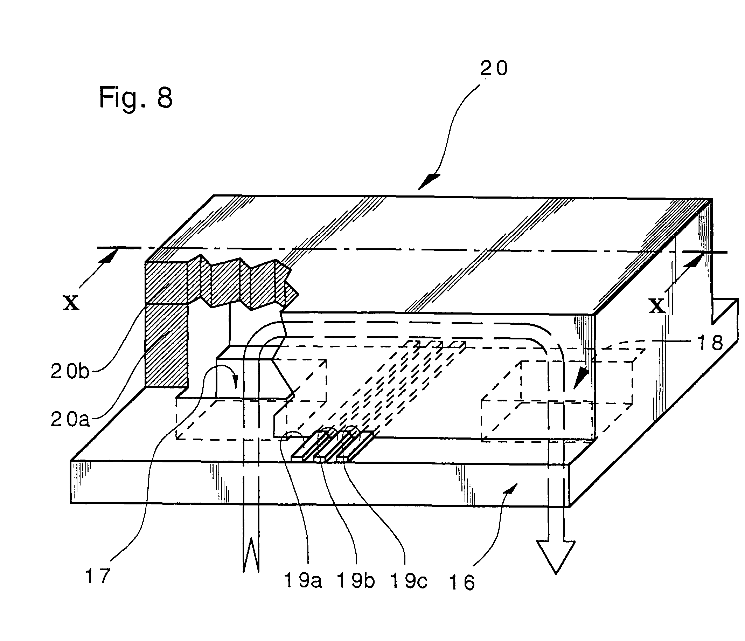

Une fois le bloc 11 formé, on le libère du substrat, comme indiqué dans l'exemple 1 (figure 7), puis on élimine la structure positive, qui correspond en fait à la microstructure représentée à la figure 1. A cet effet, le photorésist polymérisé peut être dissous par la N-méthylepyrrolidone (NMP) ou éliminé par une attaque plasma.

Le bloc 11 est enfin usiné, individuellement ou avec le lot formé sur la plaquette-support, de façon à être adapté à une machine d'injection de matériaux plastiques en fusion. Selon des techniques connues dans ce domaine, les ouvertures 12, qui étaient initialement orientées vers la plaquette-support, sont obturées par un capot d'injection traversé par des canaux d'amenée desdits matériaux plastiques en fusion. Ce capot peut également comprendre une deuxième empreinte en creux également obtenue selon le procédé décrit ci-dessus.

### Exemple 3 : Fabrication d'un microcapteur de flux thermique

En référence à la figure 8, on voit qu'un microcapteur de flux thermique est formé par un capot 20 reposant sur une base 16 pourvue d'une ouverture 17 d'admission du flux, d'une ouverture 18 de sortie du flux et d'un jeu de résistances différentielles 19a, 19b, 19c, disposées, dans l'exemple représenté, sur la base 16, entre les ouvertures 17 et 18 et ayant des portions externes connectables à un appareil de mesure. L'ensemble est recouvert par un capot 20 formant un chenal entre les ouvertures 17, 18. Un tel microcapteur a de très petites dimensions de l'ordre de 2 x 1 x 1 mm, et sa fabrication la plus usuelle consiste à effectuer un micro-usinage de deux plaquettes de silicium qu'il convient ensuite d'assembler. Le procédé actuel a donc l'inconvénient de conduire à un produit relativement cher, qui ne présente toutefois pas toutes les qualités requises dans l'application envisagée en raison de la trop grande conductibilité thermique du silicium (environ 150 W/(m.K.)).

Le procédé selon l'invention permet au contraire d'obtenir un microcapteur de flux thermique bon marché, ne nécessitant aucun assemblage, et présentant en outre peu de pertes thermiques à travers le substrat en raison de la faible conductivité thermique (environ 0,1 W/(m.K.)) du polymère utilisé comme photorésist. Ce microcapteur est réalisé par structuration de trois couches de photorésist correspondant respectivement à la base 16, aux parois verticales 20a et au fond de fermeture 20b du capot 20.

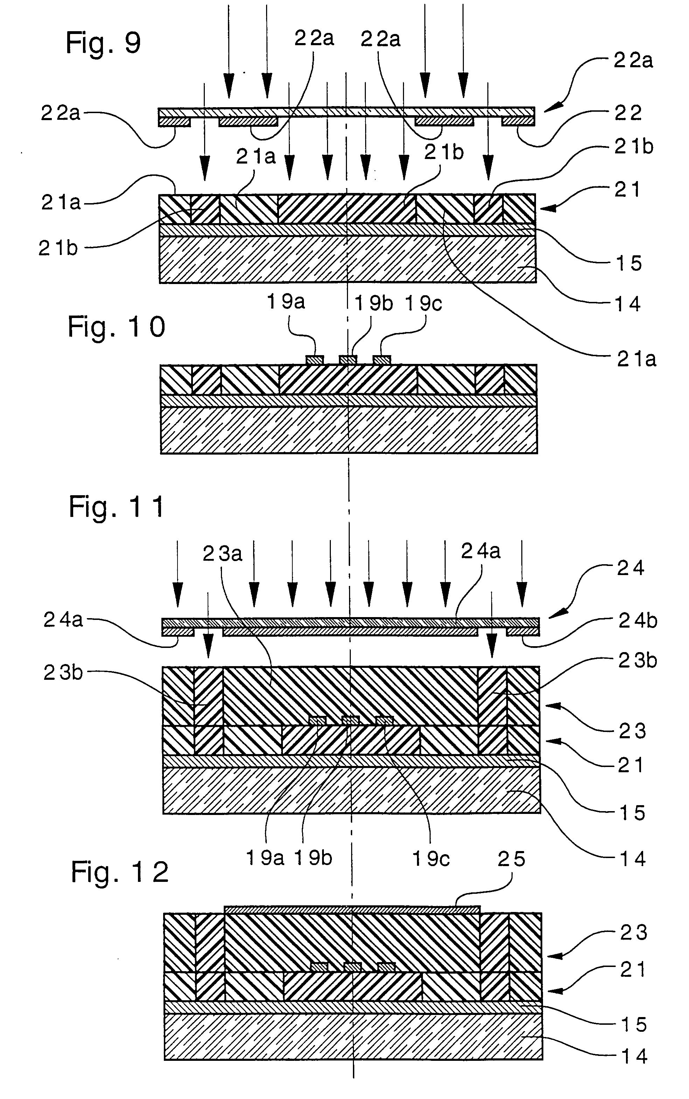

Les différentes phases de construction de ce microcapteur sont expliquées plus en détails ci-après en référence aux figures 9 à 15.

Comme représenté à la figure 9, sur un substrat en verre 14 ayant un revêtement sacrificiel 15, on a déposé à la tournette une couche 21 du même photorésist que celui utilisé dans l'exemple 1, sur une épaisseur de 150 µm, effectué un chauffage à 95°C pendant environ 60 mn, puis disposé au-dessus de sa surface un masque 22 dont les zones 22a revêtues de chrome et faisant obstacle au rayonnement ultraviolet sont situées à l'extérieur du périmètre de la base 16 et au-dessus des ouvertures 17, 18. Après une illumination UV d'environ 300 mJ/cm² et un recuit à environ 95°C pendant environ 15 minutes, on obtient la polymérisation des zones 21b, c'est-à-dire de toute la base 16 à l'exception du photorésist 21a présent dans les ouvertures 17, 18 et à la périphérie de la base 16 qui sera éliminé ultérieurement.

A la figure 10, on a représenté l'étape de dépôt des résistances 19a, 19b, 19c. Ce dépôt est effectué par les techniques bien connues de photolithographie et ne sera donc pas décrit davantage. Ces résistances sont par exemple constituées par un dépôt de 100 nm de chrome et de 50 nm d'or.

La figure 11 correspond à la structuration des parois 20a du capot 20 selon le même processus que celui décrit pour la figure 9. La couche de photorésist déposée 23 a une épaisseur de 300 µm et le masque 24 comporte des zones chromées 24a qui délimitent le périmètre des parois. Après illumination UV et recuit, les zones 23b, qui prolongent les zones 21b polymérisent et les résistances 19a, 19b, 19c sont noyées dans le photorésist non polymérisé 23a.

A la figure 12, on a représenté une étape intermédiaire consistant à protéger la zone 23a par un dépôt métallique 25 recouvrant toute l'ouverture du capot 20. Comme pour les résistances, ce dépôt est effectué par les techniques bien connues de photolithographie et ne sera pas décrit davantage. Il est par exemple constitué par un dépôt de 50 nm de chrome et de 300 nm de cuivre.

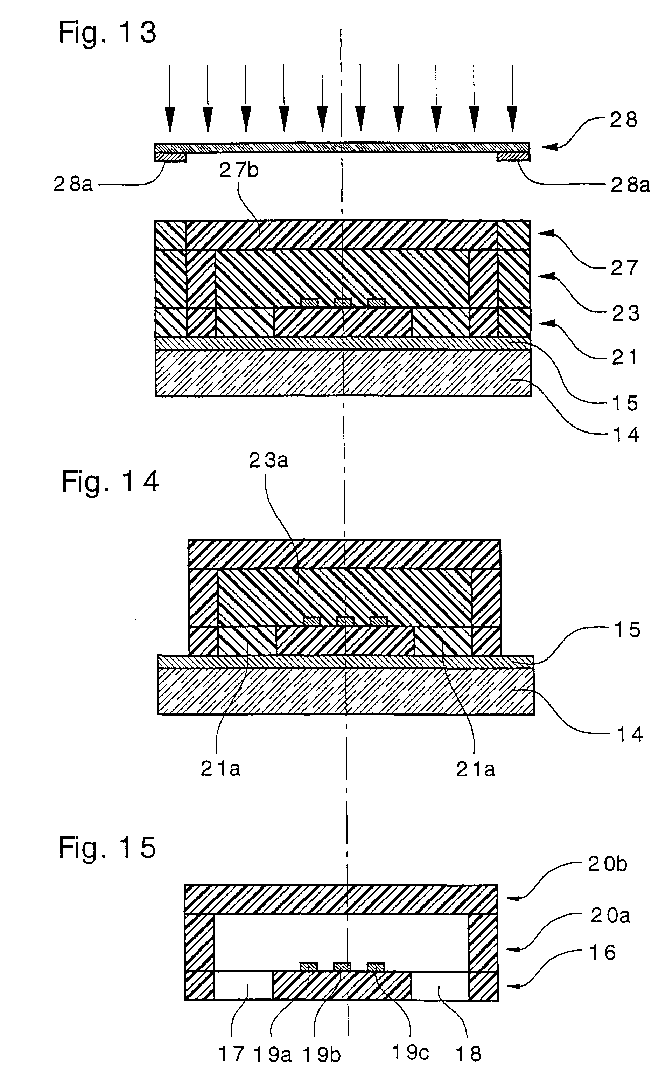

La figure 13 représente la structuration d'une troisième couche 27 de 150 µm de photorésist au moyen d'un troisième masque 28 dont les zones 28a revêtues de chrome délimitent un contour rectangulaire correspondant au fond 20a du capot 20.

La figure 14 représente la première phase de développement qui laisse apparaître le microcapteur, encore solidaire de la plaquette-support 14 et du revêtement sacrificiel 15, et emprisonnant les fractions 21a et 23a de photorésist non polymérisé.

Comme représentée à la figure 15, après libération totale de la structure une deuxième phase de développement permet d'éliminer les fractions 21a et 23a.

Le développement et l'élimination du revêtement sacrificiel s'effectue comme indiqué dans l'exemple 1. Pour le développement, on utilisera de préférence un bain de PGMEA à 50°C pendant 15 à 30 mn, suivi d'un rinçage à l'isopropanol.

Le procédé qui vient d'être décrit n'est pas limité à l'obtention de microstructures données à titre d'exemples et l'homme de l'art est en mesure de concevoir d'autres constructions sans sortir du cadre de l'invention.

## Revendications

1. Procédé de fabrication d'une microstructure tridimensionnelle, **caractérisé en ce qu'**il comprend les étapes consistant a :
a) créer sur une plaquette-support (4) un revêtement sacrificiel (5) ;
b) étaler en une seule fois une couche (6, 21) de photorésist négatif, sensible au rayonnement ultraviolet, d'une épaisseur comprise entre 150 µm et 700 µm, ledit photorésist étant formé par une laque contenant une composition époxy polyfonctionnelle et un photoinitiateur choisi parmi les sels de triarylsulfonium;
c) chauffer ladite couche (6, 21) entre 90 et 95°C pendant une durée dépendant de l'épaisseur déposée;
d) effectuer à travers un masque (7, 12) correspondant à l'empreinte désirée une illumination UV de 200 à 1'000 mJ.cm⁻² mesurée à une longueur d'onde de 365 nm selon l'épaisseur de la couche;
e) effectuer un recuit de ladite couche (6, 21) pour provoquer la polymérisation;
f) reproduire au moins une fois les étapes b) à e) en utilisant, si nécessaire en fonction du contour désiré pour la structuration de la nouvelle couche (8, 23, 27) de photorésist, un masque (9, 24, 28) différent pour l'étape d);
g) procéder en une ou plusieurs fois au développement par dissolution du photorésist non exposé au moyen d'un solvant choisi parmi la GBL (gammabutyrolactone) et le PGMEA (propylène glycol méthyle éthyle acétate), et
h) séparer de la plaquette-support (4) la microstructure obtenue à l'étape g) par dissolution du revêtement sacrificiel (5).

2. Procédé selon la revendication 1, **caractérisé en ce que** le recuit de l'étape e) est effectué de préférence entre 90°C et 95°C pendant 15 à 30 mn.

3. Procédé selon la revendication 1, **caractérisé en ce que** la plaquette-support est choisi parmi les plaquettes de silicium de verre ou de céramique.

4. Procédé selon la revendication 1, **caractérisé en ce que** le revêtement sacrificiel d'accrochage est choisi parmi les métaux, tel que l'aluminium, et les matériaux plastiques composites.

5. Procédé selon les revendications 1 et 4, **caractérisé en ce que** l'agent chimique permettant de libérer la microstructure du substrat est du KOH 40 % pour un revêtement sacrificiel en aluminium.

6. Procédé selon la revendication 1, **caractérisé en ce qu'**il comprend en outre, avant l'une des étapes f), une étape supplémentaire i) consistant à effectuer un dépôt métallique (25) destinée à protéger du rayonnement UV une zone déterminée d'une couche basse de photorésist.

7. Procédé selon la revendication 1, **caractérisé en ce qu'**il comprend en outre, avant la libération de la structure de la plaquette-support une étape supplémentaire ii) consistant à recouvrir la microstructure obtenue à l'issue de l'étape g) d'une métallisation primaire puis à former un bloc métallique par dépôts électrolytiques successifs, et dans une étape iii) suivant l'étape h) à éliminer par des moyens physiques ou chimiques ladite microstructure pour former un micromoule.

8. Microstructure obtenue selon la revendication 1, **caractérisée en ce que** la première couche de photorésist est structurée en formé de roue dentée (1) et la deuxième couche de photorésist en forme de pignon (2).

9. Microstructure obtenue selon la revendication 6, **caractérisée en ce que** la structuration de trois couches de photorésist permet d'obtenir une microstructure creuse pourvue de deux ouvertures (17, 18) positionnées de part et d'autre de trois résistances (19a, 19b, 19c) pour former un microcapteur thermique.

## Claims

1. Method for manufacturing a three-dimensional microstructure, **characterised in that** it comprises the steps of :
a) creating a sacrificial coating (5) on a support plate (4);
b) spreading in a single operation a layer (6, 21) of negative photoresist which is sensitive to ultraviolet radiation, of a thickness between 150 µm and 700 µm, said photoresist being formed by a resin which contains a polyfunctional epoxy composition and a photoinitiator chosen from the salts of triaryl sulfonium;
c) heating said layer (6, 21) between 90 and 95 °C for a time which is dependent on the deposited thickness;
d) effecting through a mask (7, 12), which corresponds to the desired shape, a UV illumination of 200 to 1000 mJ·cm⁻², measured with a wavelength of 365 nm according to the thickness of the layer;
e) effecting an annealing of said layer (6, 21) in order to bring about polymerisation;
f) reproducing at least once the steps b) to e) by using, if necessary as a function of the desired contour for the structuring of the new layer (8, 23, 27) of photoresist, a different mask (9, 24, 28) for step d);
g) proceeding one or more times to the development by dissolution of the non-exposed photosensitive resist by means of a solvent chosen from GBL (gammabutyrolactone) and PGMEA (propylene glycol methyl ethyl acetate), and
h) separating from the support plate (4) the microstructure obtained in step g) by dissolution of the sacrificial coating (5).

2. Method according to claim 1, **characterised in that** the annealing of step e) is effected preferably between 90 °C and 95 °C for 15 to 30 min.

3. Method according to claim 1, **characterised in that** the support plate is chosen from plates of silicon, glass or ceramic.

4. Method according to claim 1, **characterised in that** the sacrificial attachment coating is chosen from emtals, such as aluminium, and composite plastic materials.

5. Method according to claims 1 and 4, **characterised in that** the chemical agent which allows the microstructure of the substrate to be released is KOH 40 % for a sacrificial coating made of aluminium.

6. Method according to claim 1, **characterised in that** it comprises in addition, before one of the steps f), a supplementary step i) which comprises effecting a metallic deposit (25) which is intended to protect a specific zone of a low layer of photoresist from UV radiation.

7. Method according to claim 1, **characterised in that** it comprises in addition, before releasing the structure of the support plate, a supplementary step ii) which comprises covering the microstructure obtained at the end of step g) with a primary metallisation then forming a metallic block by means of successive electrolytic depositions, and in a step iii) following step h) eliminating said microstructure by physical or chemical means in order to form a micromould.

8. Microstructure obtained according to claim 1, **characterised in that** the first layer of photoresist is structured in the shape of a toothed wheel (1) and the second layer of photoresist in the shape of a pinion (2).

9. Microstructure obtained according to claim 6, **characterised in that** the structuring of three layers of photoresist allows a hollow microstructure to be obtained which is provided with two openings (17, 18) positioned on both sides of three resistors (19a, 19b, 19c) in order to form a thermal microsensor.

## Patentansprüche

1. Verfahren zum Herstellen einer dreidimensionalen Mikrostruktur, **dadurch gekennzeichnet, daß** es die Schritte umfaßt, die darin bestehen,
a) auf einem Trägerplättchen (4) eine Opferbeschichtung (5) zu erzeugen;
b) ein einziges Mal eine Schicht (6, 21) eines negativen Photoresists, der gegenüber ultravioletter Strahlung empfindlich ist, mit einer Dicke im Bereich von 150 µm bis 700 µm aufzutragen, wobei der Photoresist durch einen Lack gebildet ist, der eine polyfunktionale Epoxid-Verbindung sowie einen Photoinitiator, der unter den Triarylsulfon-Salzen ausgewählt ist, enthält;
c) die Schicht (6, 21) während einer von der aufgebrachten Dicke abhängenden Dauer zwischen 90 und 95 °C zu erhitzen;
d) eine UV-Belichtung mit 200 bis 1000 mJ/cm², die bei einer Wellenlänge von 365 nm gemessen wird, je nach Dicke der Schicht durch eine Maske (7, 12) hindurch, die dem gewünschten Abdruck entspricht, aufzubringen;
e) ein Glühen der Schicht (6, 21) auszuführen, um die Polymerisation hervorzurufen;
f) wenigstens einmal die Schritte b) bis e) unter Verwendung einer Maske (9, 24, 28), die vom Schritt d) verschieden ist, gegebenenfalls in Abhängigkeit von der gewünschten Kontur für die Strukturierung der neuen Schicht (8, 23, 27) des Photoresists zu wiederholen;
g) ein- oder mehrmals die Entwicklung durch Auflösung des nicht belichteten Photoresists mittels eines Lösungsmittels, das aus GBL (gamma-Butyrolacton) und PGMEA (Propylenglycolmethylethylacetat) gewählt ist, auszuführen, und
h) die im Schritt g) erhaltene Mikrostruktur vom Trägerplättchen (4) durch Auflösung der Opferbeschichtung (5) zu trennen.

2. Verfahren nach Anspruch 1, **dadurch gekennzeichnet, daß** das Glühen im Schritt e) vorzugsweise zwischen 90 °C und 95 °C während 15 bis 30 min ausgeführt wird.

3. Verfahren nach Anspruch 1, **dadurch gekennzeichnet, daß** das Trägerplättchen unter Plättchen aus Silicium, Glas oder Keramik ausgewählt wird.

4. Verfahren nach Anspruch 1, **dadurch gekennzeichnet, daß** die Haft-Opferbeschichtung unter den Metallen wie etwa Aluminium und den Verbund-Kunststoffen ausgewählt wird.

5. Verfahren nach den Ansprüchen 1 und 4, **dadurch gekennzeichnet, daß** das chemische Agens, das die Ablösung der Mikrostruktur vom Substrat ermöglicht, für eine Opferbeschichtung aus Aluminium 40 %ige KOH ist.

6. Verfahren nach Anspruch 1, **dadurch gekennzeichnet, daß** es außerdem vor einem der Schritte f) einen zusätzlichen Schritt i) umfaßt, der darin besteht, einen Metallniederschlag (25) auszuführen, der dazu bestimmt ist, eine bestimmte Zone der unteren Schicht des Photoresists vor der UV-Strahlung zu schützen.

7. Verfahren nach Anspruch 1, **dadurch gekennzeichnet, daß** es außerdem vor der Ablösung der Struktur vom Trägerplättchen einen zusätzlichen Schritt ii) umfaßt, der darin besteht, die am Ende des Schrittes g) erhaltene Mikrostruktur mit einer primären Metallisierung zu bedecken und dann durch aufeinanderfolgende elektrolytische Niederschläge einen Metallblock zu bilden und in einem Schritt iii) nach dem Schritt h) die Mikrostruktur durch physikalische oder chemische Mittel zu entfernen, um eine Mikroform zu bilden.

8. Mikrostruktur, die gemäß Anspruch 1 erhalten wurde, **dadurch gekennzeichnet, daß** die erste Schicht des Photoresists in Form eines Zahnrades (1) strukturiert ist und die zweite Schicht des Photoresists in Form eines Ritzels (2) strukturiert ist.

9. Mikrostruktur, die gemäß Anspruch 6 erhalten wurde, **dadurch gekennzeichnet, daß** die Strukturierung der drei Schichten des Photoresists ermöglicht, eine hohle Mikrostruktur zu erhalten, die mit zwei Öffnungen (17, 18) versehen ist, die beiderseits dreier Widerstände (19a, 19b, 19c) angeordnet sind, um einen thermischen Mikrosensor zu bilden.
